# EUROPEAN PATENT APPLICATION

(11) **EP 2 937 914 A1**
(43) Date of publication of application: **28.10.2015**
(21) Application number: 14165620.7
(22) Date of filing: 23.04.2014
(51) Int. Cl.: H01L 51/48, H01L 51/46

(54) **Water-based photoactive dispersions**

(71) Applicant: Nederlandse Organisatie voor toegepast- natuurwetenschappelijk onderzoek TNO, 2595 DA 's-Gravenhage (NL)
(72) Inventor: Andriessen, Hieronymus Antonius Josephus Maria, 2628 VK Delft (NL); Eggenhuisen, Tamara M., 2628 VK Delft (NL); Grossiord, Nadia, 2628 VK Delft (NL)
(74) Representative: Jansen, Cornelis Marinus

(57) **Abstract**

The invention relates to a method for preparing a photoactive layer on a substrate, the photoactive layer comprising a photoactive organic substance and further a fullerene, the method comprising providing an aqueous dispersion of the photoactive organic substance and the fullerene, and depositing the organic substance and the fullerene on a surface of the substrate to form the photoactive layer.

## Description

The present invention relates to a method for preparing a photoactive layer, to a method for preparing an organic photo-electronic device, to an aqueous dispersion, and the a method of making an aqueous dispersion.

Photoactive layers based on organic photoactive substances have attracted interest in the manufacture of photo-electronic devices, such as organic photovoltaic cells (OPV), which may be used as solar cells or photodetectors. This field shows great promise for delivering low-cost printable devices that may be provided on flexible substrates.

Among the concepts for OPV cells, bulk heterojunctions have become popular (BHJ). The photoactive layer of BHJ photo-voltaic cells is typically formed of an interpenetrating network of electron-donor and electron-acceptor domains.

According to A.J. Moulé and K. Meerholz (Adv. Funct. Mater. 2009, 19, 3028-3036), favoured materials for OPV's are electron-conducting fullerenes as acceptor materials and hole-conducting organic polymers as donor material. Various technologies are under development for effectively forming a photoactive layer from these materials. The morphology on a nanoscale of electron-donating regions and electron-accepting regions in the photoactive layer is of key-importance for the performance of the device. Moulé and Meerholz observe that morphologies can be achieved by using fully dissolved polymer/fullerene blends in specific situations, but that to achieve a greater control of morphology more sophisticated fabrication methods would be necessary. Also the photoactive substances and the fullerenes are generally insoluble in polar solvents, which means that generally use is made of apolar organic solvents, such as chlorinated aromatic solvents, which are undesirable from an environmental or health perspective.

Kietzke et al. (Nature Materials Vol 2 June 2003) describe a method wherein the photoactive organic substance is dissolved in a liquid non miscible with water, such as xylene or chloroform, which solution is then emulsified in water using a surfactant. It still requires the needs of aromatic or chlorinated solvents, and in addition the use of a surfactant. Surfactants may be incorporated as an impurity in the photoactive layer. Further, the average particle size was relatively high, larger than 50 nm.

There remains a need for alternative methodologies to prepare an organic photoactive layer for a photo-electronic device, such as a photovoltaic cell, in particular an alternative that does not require the use of an aromatic or chlorine-containing solvent and that is suitable to provide a photoactive layer with a satisfactory morphology for use in a photo-electronic device, also in the absence of added surfactants.

The inventors have now surprisingly found that it is possible to provide a dispersion of a photoactive substance (insoluble in water) and a fullerene (insoluble in water) in water that is essentially free of other solvents and additional surfactants and that such a dispersion is suitable for preparing a working photoactive layer of an electronic device, such as a photovoltaic cell.

Accordingly, the present invention relates to a method for preparing a photoactive layer on a substrate, the photoactive layer comprising a photoactive organic substance and further a fullerene, the method comprising providing an aqueous dispersion of the photoactive organic substance and the fullerene, and depositing the organic substance and the fullerene on a surface of the substrate to form the photoactive layer.

Further, the invention relates to an aqueous dispersion of a photoactive organic substance and a fullerene wherein the dispersion is essentially free of liquids other than water and wherein the dispersion is essentially free of surfactants.

Further, the invention relates to a method for preparing an aqueous dispersion of a photoactive organic substance and a fullerene, the method comprising making a dispersion of the photoactive organic substance and the fullerene in a liquid comprising water and tetrahydrofuran (THF) or another auxiliary solvent in which the organic substance is soluble and which auxiliary solvent is inter-miscible with water, and thereafter removing THF or other auxiliary solvent from the dispersion, thereby forming the aqueous dispersion.

### Brief description of the drawings:

Figure 1 DLS particle size measurement for dispersion as prepared by the procedure described in Example 1, P3HT as is and PCBM as is are the separate dispersions used to make the final dispersion, P3HT/PCBM-THF is the dispersion after THF removal as described in this Example.
Figure 2 Cryo-transmission electron micrograph image of P3HT/PCBM dispersion prepared according to Example 1 at liquid N₂ temperature.
Figure 3 I-V curves for organic photovoltaic devices with an inverted architecture with a P3HT/PCBM layer deposited from a dispersion prepared according to the procedure described in Example 1.
Figure 4 Fluorescence measurements of dispersions of (a) P3HT in water, (ah) P3HT in water after THF removal, (ab) P3HT/PCBM dispersion in water and (abh) P3HT/PCBM dispersion after THF removal prepared according to the procedure as described in Example 1.
Figure 5 Fluorescence measurements of dispersions of (A) P3HT in water, (Ah) P3HT in water after THF removal, (AB) P3HT/PCBM dispersion in water prepared from a mixed P3HT/PCBM solution and (ABh) P3HT/PCBM dispersion after THF removal prepared from a mixed P3HT/PCBM solution.
Figure 6 Cryo-transmission electron micrograph image of P3HT/PCBM nanoparticles in a dispersion prepared (left) according to the procedure described in Example 1, or (right) from a mixed P3HT/PCBM solution at liquid N₂ temperature.

It is in particular surprising that it is possible to provide a (nano)dispersion of the photoactive organic substance and the fullerene in water, wherein the photoactive organic substance and the fullerene are stably dispersed in a nanoparticulate form (wherein the individual nanoparticles may be formed of one or both of said components), in a sufficiently high concentration to allow suitable application of the photoactive layer on a surface by a scalable deposition technique, without needing aromatic or chlorine containing organic solvents, also in the absence of an added surfactant. To the best of the inventors' knowledge, aqueous nano-dispersions of the individual components (either fullerene or apolar photoactive substance) are generally not sufficiently stable in the absence of surfactants and have an undesirable particle size distribution for use in the manufacture of photoactive layers.

The term "aqueous" in "aqueous dispersion" is used herein to indicate that the continuous phase of the dispersion (the liquid in which the particles are dissolved) essentially consists of water. Optionally, a trace of one or more auxiliary solvents (such as THF) used in the preparation of the dispersion may be present, but typically the total concentration of liquids other than water in the aqueous dispersion is less than 5 wt. %, preferably less than 1 wt. %, in particular less than 0.5 wt. %, more in particular less than 0.2 wt. %, based on total liquids. Generally, the aqueous dispersion is essentially free of aromatic solvents and chlorine containing solvents. As used herein, liquids are substances in the liquid physical state at 25 °C and 1 bara).

As used herein, 'essentially free of' means in particular that a component is not detectible with a conventional detection technique or that at most a trace of the component is present, typically in a concentration of less than 1 wt. %, in particular in a concentration of less than 0.2 wt. %.

The aqueous dispersion is typically a nanodispersion, *i.e.* a dispersion of nanoparticles. The term "nanodispersion" is used herein for a dispersion wherein essentially all particles dispersed in the dispersion are nanoparticles. The term "nanoparticles" is used for particles that have an average diameter (longest length scale) of less than 200 nm, as determined by dynamic light scattering.

When referred herein to a percentage, generally the weight percentage based on total weight of a composition is meant, unless specified otherwise.

The term "or" as used herein means "and/or" unless specified other wise.

The term "a" or "an" as used herein means "at least one" unless specified otherwise.

The term "substantial(ly)" or "essential(ly)" is generally used herein to indicate that it has the general character or function of that which is specified, for instance when referring to essentially spherical it means that it has at least the general appearance of a sphere. When referring to a quantifiable feature, these terms are in particular used to indicate that it is for at least 75 %, more in particular at least 95 %, even more in particular at least 99 % of the maximum that feature, unless specified otherwise.

When referring to the term 'about', this in particular includes a deviation of up to 10 % of the stated value.

When referring to a "noun" (*e.g*. a compound, an additive *etc*.) in singular, the plural is meant to be included, unless specified otherwise.

For the purpose of clarity and a concise description features are described herein as part of the same or separate embodiments, however, it will be appreciated that the scope of the invention may include embodiments having combinations of all or some of the features described.

The photoactive organic substance is typically an apolar substance. The photoactive organic substance generally is essentially insoluble in water. Thus, generally essentially all of the photoactive substance will be dispersed rather than dissolved in the aqueous dispersion. Typically, the photoactive substance is considered insoluble in water if the solubility is less than 1 mg/l, in particular less than 0.1 mg/l, more in particular less than 1 µg/l, more in particular less than 10 ng/ml. The photoactive substance is typically a substance having an electron-donor function in the photoactive layer, when exposed to light having a suitable frequency. Typically the photo-active layer is responsive to a frequency in the visible (wavelength range: 400-800 nm), ultraviolet (wavelength range: 100-400 nm) or infrared range (wavelength range:800 nm- 1mm).

Herein, 'electron-donor function' means that the substance only acts as a electron donor, or it donates more electrons than it accepts - if it also has electron accepting properties. The photoactive organic substance may be a relatively small molecule (typically a molecular weight of less than 1000 g/mol), that may be a polymerisable small molecule (monomer, or polymerisable oligomer) or a non-polymerisable small molecules. Examples of small photoactive substances are phtalocyanines (Cu, Zn) and oligothiophenes. These substances are solution processable p-type semiconducting molecules.

Further, the photoactive organic substance may be a prepolymer or a polymer. Good results have been achieved with an organic polymer. Preferred photoactive organic polymers are P3HT (Poly (3-hexylthiophene)) MDMO-PPV (Poly[2-methoxy-5-(3',7'-dimethyloctyloxy)-1,4-phenylenevinylene]), Poly-benzodithiazoles, Poly-vinyl carbazoles, Polypiridines, Poly-benzodithiophenes, Poly-phenylenes, Poly-para-phenylenes, Poly-fluorenes, Poly-pyrroles and copolymers thereof.

The fullerene typically has an electron-acceptor function in the photoactive layer. Herein, 'electron-acceptor function' means that the substance only acts as a electron acceptor, or it accepts more electrons than it donates - if it also has electron donating properties. The term fullerene is generally used herein for any fullerene, including its derivatives in which a chemical group is chemically bound to the fullerene structure, and wherein the fullerene structure is still present. The term 'derivatised fullerene' is used for fullerenes in which a chemical group is chemically bound to the fullerene structure, and wherein the fullerene structure is still present.

In principle any electron-accepting fullerene may be used. Preferred fullerenes are 'bucky ball' fullerenes, which may be selected from the group of C₂₀, C₂₆ C₆₀, C₇₀, C₇₆, C₈₂, C₈₄ and C₁₀₀ bucky ball fullerenes, including derivatives thereof. In particular, preferred bucky ball fullerenes are underivatised buckminster fullerene (C₆₀), derivatised buckminster fullerene, underivatised C₇₀-fullerene and derivatised C₇₀-fullerene. Preferred fullerene derivatives are aryl-fullerene-carboxylic acids, such as phenyl-C₆₁-butyric acid methyl ester (PC₆₀BM), phenyl-C₇₁-butyric acid methyl ester (PC₇₀BM)....) and their bis-, tris- and multiadducts; derivatives with substituted side groups, such as PCBA, [6,6]-phenyl-C 61-butyric acid n-butyl ester, [6,6]-phenyl-C 71-butyric acid n-butyl ester, indene-fullerene monoadduct, indene-fullerene bisadduct, perylene derivatives (3,4,9,10-perylene tetracarboxylic bis-benzimidazole), tetrabenzoporphyrin derivatives.

The substrate can in principle be any substrate on which the layer can be deposited. The surface of the substrate can be a polymer, a glass, a ceramic, an oxide, silicon, a metal or paper. The surface of the substrate is typically the surface of a part of a photo-electronic device to which the photoactive layer is usually supplied. As is generally known, typically, the manufactured photo-electronic device comprises at least two electrodes and the photoactive layer. The photoactive layer is usually provided between two electrodes. This minimum structure can be supported by one or more of: a carrier material, a barrier layer (in particular a moisture barrier layer and/or an oxygen barrier layer), one or more additional interlayers for improved performance. Interlayers are generally situated between an electrode and the photoactive layer. Interlayers can have a hole blocking or electron blocking function. An example of an interlayer is a buffer layer, such as a buffer layer on a positive electrode (upon which the photoactive layer is provided such that the buffer layer is present between the photoactive layer and the positive electrode).

Thus, the substrate can be an electrode or an interlayer, such as a buffer layer or an electron or hole transport layer for the electronic device.

Preferred electronic devices to be manufactured in accordance with the invention are photo-voltaic cells, in particular solar cells. Good results have been achieved with a method wherein the photoactive layer is deposited on a zinc oxide layer.

The thickness of the layer can be chosen within wide limits, dependent on the device that is to be made; usually within the range of 10-1000 nm, in particular within the range of 50-400 nm, more in particular in the range of 150-250 nm.

In principle the deposition can be performed with any known deposition technique for applying an organic photoactive layer. Preferably, a scalable deposition technique is used. Suitable techniques in particular include slot die coating, ink jet printing, spray coating, blade coating, curtain coating, flexographic printing, gravure printing, spin-coating and drop-casting.

The aqueous dispersion used for the deposition whereby the photoactive layer is formed, preferably comprises at least 0.05 wt. %, based on total weight of the dispersion, of photoactive substance. In particular for applying a layer with advantageous homogeneity in thickness and/or an advantageous morphology, it is preferred that the photoactive substance concentration is at least 0.5 wt. %, in particular at least 1.0 wt. %. Usually the photoactive substance concentration is 6 wt. % or less, based on total weight of the dispersion, preferably 4 wt. % or less, in particular 3 wt. % or less. In a specifically preferred embodiment the photoactive substance concentration is about 2 wt. %.

The aqueous dispersion used for the deposition whereby the photoactive layer is formed, preferably comprises at least 0.05 wt. % fullerene, based on total weight of the dispersion. In particular for applying a layer with advantageous homogeneity in thickness and/or an advantageous morphology, it is preferred that the fullerene concentration is at least 0.5 wt. %. In a specifically preferred embodiment the fullerene concentration is at least 1.0 wt. %. Usually the fullerene concentration is 6wt. % or less, based on total weight of the dispersion, preferably 4 wt. % or less, in particular 3 wt. % or less. In a specifically preferred embodiment the fullerene concentration is about 2 wt. %.

The wt. to wt. ratio photoactive substance to fullerene usually is in the range of 30:70 to 70:30, preferably in the range of 40:60 to 60:40, more preferably about 50:50.

Advantageously, at least 90 % in particular at least 99 % of the weight of the particles in a dispersion (for use) according to the invention is formed by particles having a an average hydrodynamic diameter of less than 200 nm, in particular less than 175, more in particular 150 nm or less, as determined by dynamic light scattering.

Preferably essentially all particles in the dispersion have an average size of less than 200 nm.

The number average particle size of the particles in the aqueous dispersion preferably is in the range of 10-50 nm, more preferably in the range of 10-20 nm. This parameter can be determined by TEM.

The particles in the aqueous dispersion may have an essentially monomodal particle size distribution or a polymodal, e.g. bimodal particle size distribution.

Any of particles in the dispersion may be either essentially pure fullerene or essentially pure photoactive substance particles, or the particles may be composites of both fullerene and photoactive substance. For instance, the dispersion may comprise particles having a core-shell morphology, with photoactive substance as the core and fullerene as the shell or *vice versa.*

The aqueous dispersion is generally essentially free of liquids other than water. Further, in an advantageous embodiment, the aqueous dispersion is essentially free of added surfactants.

After depositing the photoactive layer on the substrate, the layer may be treated in a manner based on methodology known *per se, e.g.* based on the above mentioned prior art or references cited therein. In particular the layer may be dried. Further, the layer may be subjected to a thermal annealing step. Annealing may be advantageous in order to structurise the layer, such that the transport of electrons or holes is better directed in the desired direction (typically in a plane parallel to the surface of the substrate). In a specific embodiment, the photoactive layer has a satisfactory structure to favour the direction of electron/hole transport without subjecting the layer to a thermal annealing step.

The invention further relates to a method for preparing an aqueous dispersion of a photoactive organic substance and a fullerene. Such method comprises making a dispersion of the photoactive organic substance and the fullerene in a liquid comprising water and tetrahydrofuran (THF) or another auxiliary solvent in which the organic substance is soluble and which auxiliary solvent is inter-miscible with water, and thereafter removing THF or other auxiliary solvent from this dispersion, thereby forming the aqueous dispersion.

Particularly good results have been achieved with THF. Further, the auxiliary solvent may in particular be selected from the group of acetone, methylethylketone, ethylacetate, dioxane and dimethylsulphoxide (DMSO).

The dispersion of fullerene and organic photoactive substance in water and auxiliary solvent is advantageously prepared by first providing separate dispersions of respectively the fullerene and of the organic photoactive substance are made. Herein, the method of preparing the dispersion in water and auxiliary solvent comprises making a first dispersion of photoactive organic substance water+auxiliary solvent (without the fullerene) and a second dispersion of fullerene in water+auxiliary solvent (without the photoactive organic substance). Based on fluorescence measurements, it has been concluded that this method allows preparation of an aqueous dispersion wherein distinct photoactive organic substance nanoparticles and fullerene nanoparticles remain dispersed. Further, this method is advantageous in that a narrower particle size distribution has been observed and a smaller average particle size, compared to a comparable method wherein the dispersion is made by dispersing fullerene and photoactive organic together without first making separate dispersions.

It has been found that it is advantageous to prepare the dispersions in water and auxiliary solvent in a specific manner, namely, using a method wherein a first essentially water-free solution of photoactive substance in auxiliary solvent is made and a second essentially water-free solution of fullerene in auxiliary solvent is made. Thereafter said first dispersion and said second dispersion are separately mixed with water to form a third dispersion of photoactive substance in auxiliary solvent plus water and a fourth dispersion of fullerene in auxiliary solvent plus water. This is advantageously accomplished by gradually adding the first respectively second dispersion to water.

Thereafter the auxiliary solvent can be removed. In principle, this can be done before mixing the dispersion of fullerene and the dispersion of photoactive organic substance. Good results have been achieved though by first mixing the third and the fourth dispersion to obtain a dispersion of fullerene and photoactive organic substance in water plus auxiliary solvent, and thereafter removing the auxiliary solvent.

The concentration of fullerene in the dispersion in auxiliary solvent is usually at least 0.01 wt. %, preferably at least 0.03 wt. %, in particular at least 0.05 wt. %, based on total weight. The concentration of fullerene in the dispersion in auxiliary solvent usually is 0.3 wt. % or less, preferably 0.1 wt. % or less, in particular 0.075 wt. % or less, based on total weight.

The concentration of photoactive organic substance in the dispersion in auxiliary solvent usually at least 0.01 wt. %, preferably at least 0.03 wt. %, in particular at least 0.05 wt. %, based on total weight. The concentration of photoactive organic substance in the dispersion in auxiliary solvent usually is 0.3 wt. % or less, preferably 0.1 wt. % or less, in particular 0.075 wt. % or less, based on total weight.

The solution or solutions in auxiliary solvent (containing fullerene and/or photoactive substance) are preferably mixed with water in a method wherein the solution(s) in auxiliary solvent are added to the water. Preferably, the solution(s) in auxiliary solvent are added gradually to the water. The gradual addition may be stepwise, for instance drop-wise, or continuous. As a rule of thumb, if the solution(s) in auxiliary solvent are added stepwise, preferably the solution(s) in auxiliary solvent is added to the water in at least 5 steps, in particular at least 10 steps. The upper limit of steps is not critical, The number of steps may be 100000 or less, 1000 or less, or 100 or less. A gradual addition is advantageous over an essentially instantaneous mixing of both phases or of over adding water to the solution(s) in auxiliary solvent, for instance with respect to particle size distribution and/or particles morphology.

The concentration of fullerene in the solution in auxiliary solvent is usually at least 0.01 wt. %, preferably at least 0.03 wt. %, in particular at least 0.05 wt. %, based on total weight. The concentration of fullerene in the solution in auxiliary solvent usually is 0.3 wt. % or less, preferably 0.1 wt. % or less, in particular 0.075 wt. % or less, based on total weight.

The concentration of photoactive organic substance in the solution in auxiliary solvent usually at least 0.005 wt. %, preferably at least 0.01 wt. % , more preferably at least 0.03 wt. %, in particular at least 0.05 wt. %, based on total weight. The concentration of photoactive organic substance in the solution in auxiliary solvent usually is 1 wt. % or less, preferably 0.5 wt. % or less, in particular 0.3 wt. % or less, more in particular 0.1 wt. % or less, based on total weight.

In an advantageous embodiment, a dispersion formed in a method of preparing the aqueous dispersion is subjected to filtration to remove particulate contaminants (oversized particles). The filter usually is filter with a pore size of about 0.5 µm (e.g. 0.45 µm) or less. The filter usually has a pore size of at least 0.1 µm, e.g. at least 0.2 µm.

In an advantageous embodiment, the dispersion(s) in water+auxiliary solvent is (are) filtered, or filtering takes place during the preparation of the dispersion(s) in water+auxiliary solvent.

The preparation of any of the dispersion may be carried out with or without ultrasonication.

The concentration of fullerene in the dispersion in water+auxiliary solvent is usually 0.01-0.3 wt. %, preferably 0.01-0.1 wt. %, in particular 0.02 to 0.05 wt. % based on total weight.

The concentration of photoactive organic substance in the dispersion in water+auxiliary solvent is usually 0.01-0.3 wt. %, preferably 0.01-0.1 wt. %, in particular 0.02 to 0.05 wt. % based on total weight.

The solids concentration is the dispersion in water+auxiliary solvent is usually 0.001-0.3 wt. %, in particular 0.005-0.2 wt. %, more in particular 0.007-0.1 wt. %, based on total weight.

The weight to weight ratio of auxiliary solvent (in particular THF) to water in the dispersion wherein the liquid phase is a mixture of water and auxiliary solvent of fullerene and organic photoactive substance in water+auxiliary solvent usually is at least 5:95, preferably at least 10:90. Said ratio usually is 50:50 or less, preferably 30:70 or less.

The temperature at which fullerene or photoactive substance is solubilised/dispersed in auxiliary solvent or a mixture of water and auxiliary solvent is usually between ambient temperature (20 °C) and the boiling point of the solvent (at the pressure at which the solubilisation/dispersion takes place), in particular at a temperature in the range of 30 to 60 °C.

The aqueous dispersion is formed by removing auxiliary solvent, preferably to the extent that essentially all auxiliary solvent is removed from the liquid phase (e.g. to a concentration of less than 0.1 wt% in the liquid phase). Suitable removal techniques include evaporation, nanofiltration and pervaporation .

In a specific embodiment, after removal of the auxiliary solvent, the photoactive substance content is 0.005-1 wt. %, in particular about 0.008 wt. %. In such embodiment, the fullerene content after removal of the auxiliary solvent photoactive substance content is usually 0.005-1 wt. %, in particular about 0.008 wt. % (without performing a concentration step).

Further, the dispersion of fullerene and photoactive substance in water+auxiliary solvent or the aqueous dispersion is advantageously subjected to a concentration step, effective to increase the solids content in the dispersion. The concentration step preferably comprises removal of water by ultrafiltration or water evaporation. Advantageously, the dispersion is concentrated up to 1000 times, in particular up to 500 times. Usually the concentration factor is at least 10 times, in particular at least 20 times, more in particular at least 50 times. Suitable methodologies are known in the art.

Usually, the aqueous dispersion according to the invention contains at least 0.02 wt. % fullerene, preferably at least 0.1 wt. % fullerene, more preferably at least 0.3 wt. % fullerene. The concentration of fullerene in the aqueous dispersion usually is 1 wt. % or less, in particular 0.5 wt. % or less, more in particular 0.4 wt. % or less.

Usually, the aqueous dispersion according to the invention contains at least 0.02 wt. % organic photoactive substance, preferably at least about 0.1 wt. % organic photoactive substance, more preferably at least 0.3 wt. % organic photoactive substance. The concentration of organic photoactive substance in the aqueous dispersion usually is 4 wt. % or less, preferably about 2 wt. % or less, in particular 0.5 wt. % or less.

The wt. to wt. ratio fullerene to organic photoactive substance in the aqueous dispersion usually is in the range of 20:80 to 80:20, preferably in the range of 35:65 to 65:35, in particular in the range of 40:60 to 60:40.

The invention will now be illustrated by the following examples.

### Examples

### Example 1

Solutions of poly(3-hexylthiophene) (P3HT) and of the fullerene derivative phenyl-C61-butyric acid methyl ester (PCBM) were dissolved at 0.05 wt% of each active component in THF (anhydrous, no inhibitor) by stirring at 55 °C for at least 1 hour. A concentration of 0.075 wt% also resulted in successful dispersion formation, without substantial visible formation of large particles (>5 □m) or formation of turbid dispersions.

The warm solutions were added drop-wise to fast stirring HPLC grade H₂O while filtering over a 0.45 µm PTFE filter to remove particulate contaminations. Instantaneous addition of all the THF solutions lead formation of large particles and mixing by ultrasonication also lead to formation of large particles. In total, 1 mL of THF solution was added to 5 g of H₂O, resulting in a solid concentration of 0.008 wt% in water. Up to 1.5 mL was added to 5 g without significant formation of large particles. At a larger scale 10 mL of THF solution was added in 1 mL steps to 50 g of stirring preheated water.

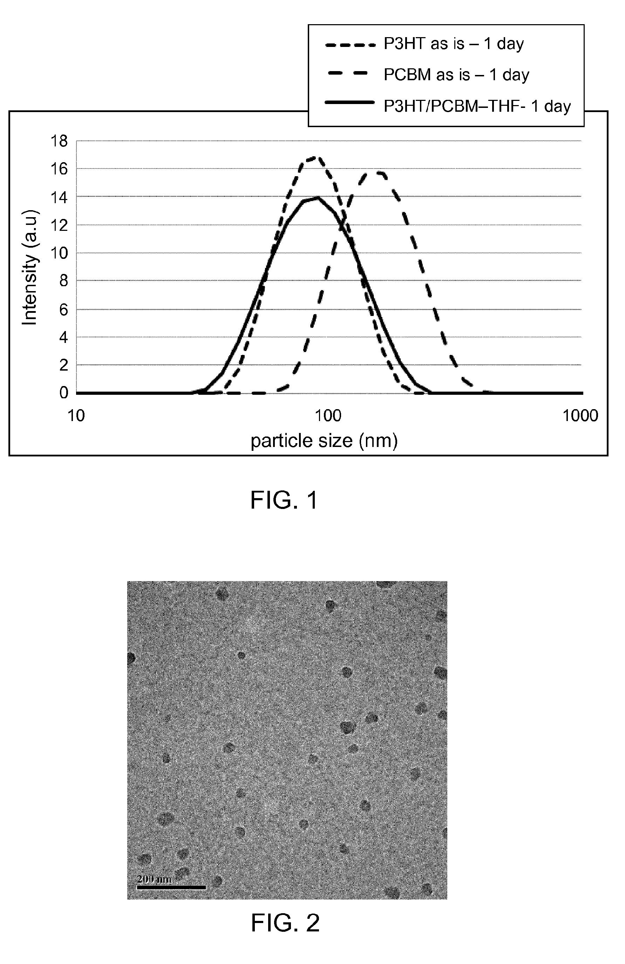

THF was removed from the dispersions by heating at 60 °C under ambient pressure, but can also be removed by a rotary evaporator, ultrafiltration or other methods. After the THF is completely removed by heating for at least 3 hours (judged by smell), the solid contents of the dispersion can be further increased by continued heating and water evaporation. The average particle size of the dispersions were measured by dynamic light scattering and the particle size distribution of the P3HT, PCBM and P3HT/PCBM dispersion after THF removal are shown in Figure 1. Indeed a monomodal particle size distribution is obtained, with an average particle size of 81 nm. The particle size was further analysed by cryogenic transmission electron microscopy of the frozen dispersion. Figure 2 shows a typical micropgraph of the P3HT/PCBM dispersion as obtained by the procedure here described. Most particles observed are in the range of 20-80 nm, indicating a slight overestimation of the particle size by DLS.

Table 1 shows the average particle size as measured by DLS, for a dispersion prepared according to the procedure described above, after THF removal. After 51 days of aging the average particle size did not change, indicating a good stability of the dispersions. Upon concentrating by removal of water by heating, the average particle size slightly increased, but still showed a monomodal particle size distribution, indicating a stable and well-defined dispersion.

**Table 1 Average particle size and polydispersity of dispersions prepared as described in Example 1 , as determined by DLS.**

| **dispersion as described in Example 1** | **average particle size (PDI) (nm)** |
|---|---|
| after THF removal | 81 (0.13) |
| after THF removal and 51 days of aging | 83 (0.13) |
| after THF removal and 4-fold concentrating | 121 (0.10) |

### Example 2

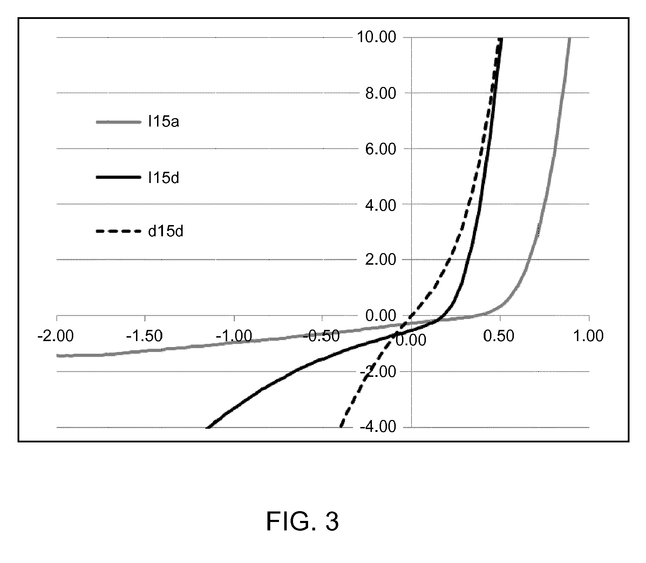

The aqueous dispersion (containing ∼0.1 wt% solids) was applied by drop casting on a ZnO from Zn acetylacetonate as electron transport layer to form a photoactive layer film for an inverted device structure. After evaporation of a MoOₓ/Ag electrode, the I-V curve was measured under simulated sunlight (100 W/cm²). Table 2 summarises the I-V characteristics of two functioning active areas of 4 and 81 mm² respectively. Figure 3 shows the I-V curve where a clear photodiode behaviour can be distinguished.

**Table 2 IV characteristics of devices with a P3HT/PCBM layer deposited from a dispersion prepared according to the procedure as described in Example 1.**

| | Voc (V) | Isc (mA/cm²) | FF (%) | MPP (mW/cm²) |
|---|---|---|---|---|
| 15a | 0.36 | 0.27 | 27.3 | 0.03 |
| 15d | 0.17 | 0.53 | 33.1 | 0.03 |

### Example 3

Dispersions prepared according to the procedure described in Example 1 are compared to an alternative preparation method. For this both components, P3HT and PCBM were dissolved in THF at 0.05 wt% of each, to yield a single P3HT/PCBM solution. The solution was heated at 55°C for at least an hour. 1 mL of warm solution was added drop-wise to 5 g fast stirring HPLC grade H₂O while filtering over a 0.45 µm PTFE filter to remove particulate contaminations. After addition, the solution was heated at 60 °C for at least 3 hours until all THF was removed. By dynamic light scattering an average particle size of 109 nm was measured (Table 3).

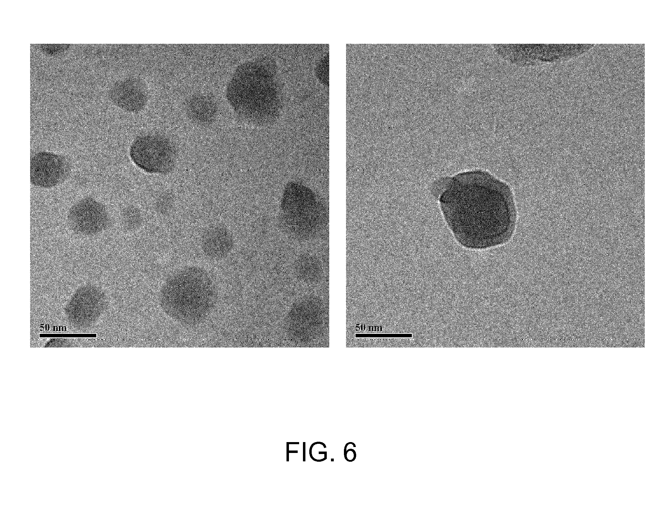

The dispersions were characterized by cryogenic transmission electron microscopy, to visualise the nanoparticles in dispersion, without any drying treatment. Figure 6 shows typical images of nanoparticles at 97.000 times magnification. The dispersion prepared according to Example 1 shows nanoparticles in the range of 50 nm as well as particles of ∼10-20 nm (left pane). The dispersion prepared according to this Example, shows slightly larger particles with a core-shell structure, indicating phase separation of the components within a single particle. Such core-shell like structure of the two components within a single nanoparticle indicates that by the procedure in this Example, different nanoparticles are obtained than by the procedure as described in Example 1.

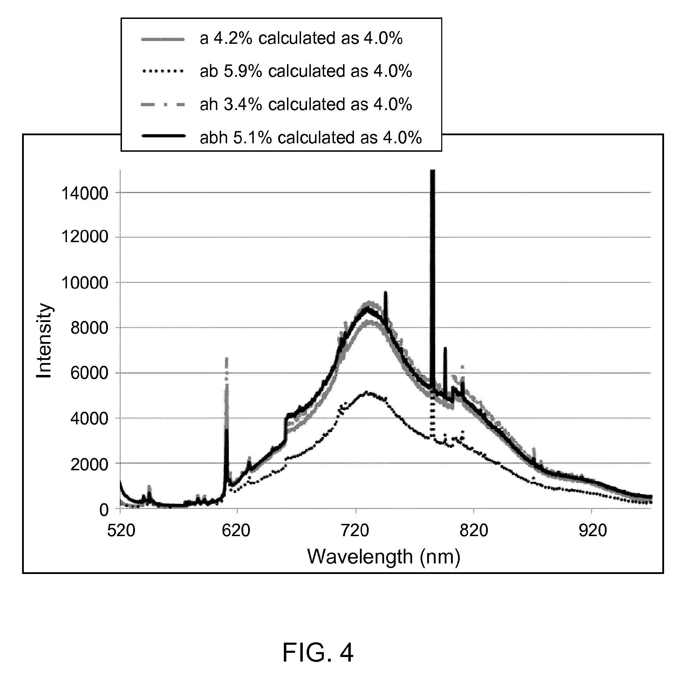

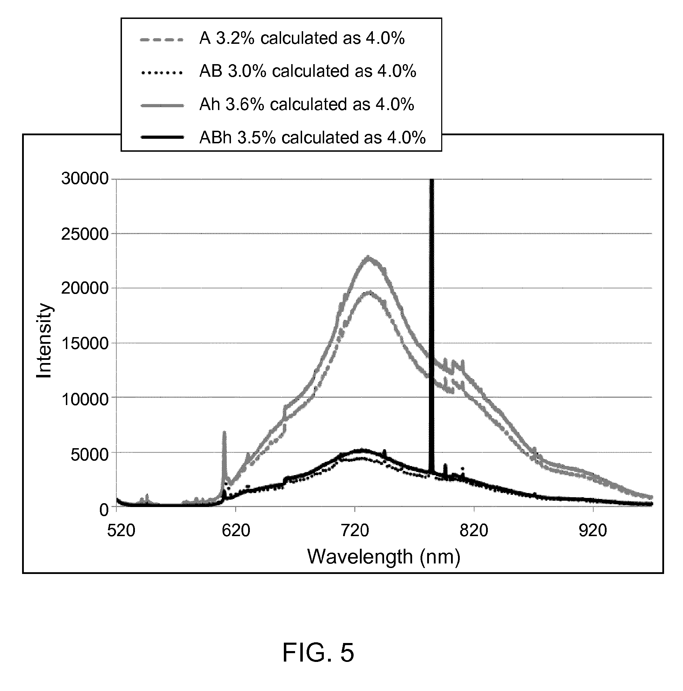

The fluorescence spectra of the dispersions prepared according to the procedure described in Example 1 were compared to the spectra of the dispersion as prepared by the procedure described in this example. In Figure 4, It is observed that the fluorescence signal of the final dispersion (indicated by "abh") is of similar intensity to a dispersion of P3HT only ("ah") at the same concentration and after the same heat treatment for THF removal. On the other hand, in Figure 5, the fluorescence signal of the dispersion as prepared in this Example ("ABh") is significantly reduced as compared to the dispersion of P3HT only ("Ah"), at the same concentration and after THF removal. The latter indicates quenching of the P3HT fluorescence by PCBM due to close proximity fo the two components. As they are present in the same nanoparticle, this yields a different dispersion as the dispersion prepared by Example 1.

### Example 4

Example 1 was repeated, except that the order of THF removal and addition of the dispersions of the separate components were varied. Table 4 shows the average particle sizes of dispersions containing P3HT and PCBM thus obtained. Adding the second component from THF solution to an already prepared dispersion of the first component yields larger particle sizes with a larger size distribution as the dispersion obtained from the procedure described in Example 1. Also, removing the THF from the dispersion containing PCBM prior to addition to the P3HT dispersion leads to a larger average particle size with a broader particle size distribution.

**Table 3 Average particle size and polydispersity of dispersions prepared according to Example 1, except variations in the order of THF removal.**

| component P3HT | component PCBM | average particle size (PDI) (nm) |
|---|---|---|
| aqueous dispersion prepared from both components in a single THF solution | | 107 (0.09) |
| in THF solution^{a} | in aqueous dispersion^{b} | 184 (0.16) |
| in aqueous dispersion | in THF solution | 284 (0.30) |
| in aqueous dispersion, THF removed^{c} | in aqueous dispersion | 116 (0.17) |
| in aqueous dispersion | in aqueous dispersion, THF removed | 148 (0.35) |

| | | |
|---|---|---|
| ^{a} 0.05 wt% solution of component, ^{b} aqueous dispersion prepared as described in Example 1 with THF still present, ^{c} aqueous dispersion of the single component prepared as described in Example 1, with THF removed by heating at 60°C for at least 2 hours. | | |

### Example 5

Example 1 was repeated except that (PCBM) was replaced by [6,6]-phenyl-C₆₁-butyric acid (PCBA). The concentrations for both components was 0.05 wt. % each. Table 4 shows the average particle size as measured by DLS for the dispersion prepared by the procedure as described in Example 1 after THF removal.

**Table 4 Particle sizes and polydispersity of dispersions with varyng components, as determined by dynamic light scattering.**

| Example | component A | component B | average particle size (PDI) (nm) |
|---|---|---|---|
| 1 | P3HT | PCBM | 123 (0.22) |
| 5 | P3HT | PCBA | 84 (0.05) |
| 6 | DTS^{a} | PCBM | 119 (0.24) |
| 6 | ZnPc^{b} | PCBM | 108 (0.16) |

| | | | |
|---|---|---|---|
| ^{a} DTS = DTS(FBTTh₂)₂ (5,5'-bis{(4-(7-hexylthiophen-2-yl)thiophen-2-yl)-[1,2,5]thiadiazolo [3,4-c]pyridine-3,3'-di-2-ethylhexylsilylene-2,2'-bithiophene), demonstrated efficiency in solar cells 7% (Nat Mater, 2012 11 44), ^{b} ZnPc = Zinc phthalocyanine, demonstrated efficiency in solar cells = 3.9 % (App Phys Lett, 2010, 97, 133304). | | | |

### Example 6

Example 1 was repeated except that P3HT was replaced by other semiconducting photoactive components, such as Zn phtalocyanine (ZnPc) or DTS(FBTTh₂)₂ (DTS). Using 0.05 wt% solutions of the active components in THF, dispersions of ZnPc/PCBM and DTS/PCBM were prepared according to the procedure in Example 1. Table 4 shows the average particle size as measured by DLS after THF removal.

### Example 7

Example 1 was repeated except that the temperature at which the THF solutions and water was kept during the synthesis were varied. As shown in Table 5, smaller average particle sizes in the range of 70-90 nm were measured if either the THF solution or the water used for the preparation of the separate dispersions or both were kept at room temperature instead of 55 C, as described in Example 1.

**Table 5 Effect of synthesis parameters on particle size as determined by DLS.**

| synthesis parameters (as Example 1, except) | average particle size (PDI) (nm) |
|---|---|
| THF solutions of both components at RT^{a} | 75 (0.11) |
| Water for both stock dispersions at RT | 88 (0.11) |
| THF solutions of both components and water at RT | 70 (0.13) |

| | |
|---|---|
| ^{a} RT = ambient temperature of lab environment | |

## Claims

1. Method for preparing a photoactive layer on a substrate, the photoactive layer comprising a photoactive organic substance and further a fullerene, the method comprising providing an aqueous dispersion of the photoactive organic substance and the fullerene, and depositing the organic substance and the fullerene on a surface of the substrate to form the photoactive layer.

2. Method according to claim 1, wherein the layer is deposited using drop casting, spin coating, slot die coating, ink jet printing, spray coating, flexographic printing, gravure printing or another scalable deposition technique.

3. Method according to claim 1 or 2, wherein the aqueous dispersion from which the photoactive organic substance and the fullerene are deposited, comprises at least 0.02 wt. %, preferably 0.02- 1 wt. % photoactive organic polymer and at least 0.02 wt. %, preferably 0.02-1 wt. % fullerene.

4. Method according to any of the preceding claims, wherein the photoactive organic substance is selected from the group of polythiopenes (such as poly(3-hexylthiophene), MDMO-PPV (Poly[2-methoxy-5-(3',7'-dimethyloctyloxy)-1,4-phenylenevinylene]), Poly-benzodithiazoles, Poly-vinyl carbazoles, Polypiridines, Poly-benzodithiophenes, Poly-phenylenes, Poly-para-phenylenes, Poly-fluorenes, Poly-pyrroles and copolymers thereof.

5. Method according to any of the preceding claims, wherein the fullerene is a bucky ball fullerene, preferably selected from the group of underivatised Buckminster fullerene, derivatised Buckminster fullerenes, underivatised C70 bucky ball fullerene and derivatised C70 bucky ball fullerene, wherein the derivatives may in particular be selected from aryl-fullerene-carboxylic acids; aryl-fullerene-esters; indene- fullerene adducts, perylene derivatives , tetrabenzoporphyrin derivatives.

6. Method according to any of the preceding claims, wherein essentially all particles in the dispersion have a size of less than 200 nm.

7. Method according to any of the preceding claims, wherein the number average particles size of the particles in the aqueous dispersion is in the range of 10-50 nm, preferably in the range of 10-20 nm.

8. Method according to any of the preceding claims, wherein the aqueous dispersion is prepared by making a dispersion of the photoactive organic substance and the fullerene in a liquid comprising water and tetrahydrofuran (THF) or another auxiliary solvent in which the organic substance is soluble and which auxiliary solvent is inter-miscible with water, and thereafter removing the THF from the dispersion before applying the dispersion to the surface of the substrate.

9. Method for manufacturing an photo-electronic device, comprising the preparation of a photoactive layer using a method according to any of the preceding claims.

10. Method according to claim 8, wherein the photo-electronic device is a photo-voltaic cell, in particular a solar cell.

11. Aqueous dispersion, said dispersion being essentially free of liquids other than water and said dispersion being essentially free of surfactants, the dispersion comprising
(i) a photoactive organic substance, preferably a substance selected from the group of polythiopenes (such as poly(3-hexylthiophene), MDMO-PPV (Poly[2-methoxy-5-(3',7'-dimethyloctyloxy)-1,4-phenylenevinylene]), Poly-benzodithiazoles, Poly-vinyl carbazoles, Polypiridines, Poly-benzodithiophenes, Poly-phenylenes, Poly-para-phenylenes, Poly-fluorenes, Poly-pyrroles and copolymers thereof; and
(ii) a fullerene, preferably a fullerene selected from the group of underivatised Buckminster fullerene, derivatised Buckminster fullerenes, underivatised C70 bucky ball fullerene and derivatised C70 bucky ball fullerene, wherein the derivatives may in particular be selected from aryl-fullerene-carboxylic acids; aryl-fullerene-esters; indene- fullerene adducts, perylene derivatives, tetrabenzoporphyrin derivatives.

12. Aqueous dispersion according to claim 11, wherein the dispersion comprises nanoparticles essentially consisting of the fullerene and nanoparticles essentially consisting of the organic photoactive substance.

13. Method for preparing an aqueous dispersion of a photoactive organic substance and a fullerene, preferably a dispersion according to claim 11 or 12, the method comprising making a dispersion of the photoactive organic substance and the fullerene in a liquid comprising water and tetrahydrofuran (THF) or another auxiliary solvent in which the organic substance is soluble and which auxiliary solvent is inter-miscible with water, and thereafter removing THF or other auxiliary solvent from the dispersion, thereby forming the aqueous dispersion.

14. Method according to claim 13, wherein the dispersion of the photoactive organic substance and the fullerene in a liquid comprising water and tetrahydrofuran (THF) or another auxiliary solvent is made by mixing a first dispersion and a second dispersion, wherein the first dispersion is a dispersion of the photoactive organic substance in a liquid comprising water and tetrahydrofuran (THF) or another auxiliary solvent, and the second dispersion is a dispersion of the fullerene in a liquid comprising water and tetrahydrofuran (THF) or another auxiliary solvent.

15. Method according to claim 13 or 14, wherein the weight to weight ratio THF or other auxiliary solvent to water before removal of THF or other auxiliary solvent is in the range of 5:95 to 50:50 in particular in the range of 10:90 to 30:70.
